**Europäisches Patentamt**

**European Patent Office**

**Office européen des brevets**

(19)

(11) Veröffentlichungsnummer: **0 224 440**
**B1**

(12)

# EUROPÄISCHE PATENTSCHRIFT

(45) Veröffentlichungstag der Patentschrift:
16.08.89

(51) Int. Cl.⁴: **B65G 17/46,** H05K 13/00

(21) Anmeldenummer: **86810491.0**

(22) Anmeldetag: **31.10.86**

(54) **Transportvorrichtung für Platten.**

(30) Priorität: **08.11.85 CH 4820/85**

(43) Veröffentlichungstag der Anmeldung:
**03.06.87 Patentblatt 87/23**

(45) Bekanntmachung des Hinweises auf die Patenterteilung:
**16.08.89 Patentblatt 89/33**

(84) Benannte Vertragsstaaten:
**AT BE CH DE ES FR GB IT LI NL SE**

(56) Entgegenhaltungen:
DE-A- 2 134 985
DE-A- 2 519 610
DE-A- 2 525 496
FR-A- 2 439 734
FR-A- 2 465 665
US-A- 2 819 784

**PATENTS ABSTRACTS OF JAPAN, Band 7,
Nr. 110 (M-214)[1255], 13th May 1983; &
JP-A-58 31 811 (HITACHI SEISAKUSHO K.K.) 24-02-1983**

(73) Patentinhaber: **CIBA-GEIGY AG, Klybeckstrasse 141,
CH-4002 Basel(CH)**

(72) Erfinder: **Martin, Peter, Gerbergässlein 18,
CH-4051 Basel(CH)**
Erfinder: **Singenberger, Hansjörg, Altweg 25,
CH-8905 Arni(CH)**
Erfinder: **Lechleitner, Viktor, Im Wingert 1,
CH-8049 Zürich(CH)**

EP 0 224 440 B1

ACTORUM AG

## Beschreibung

Die Erfindung betrifft eine Transportvorrichtung gemäss Oberbegriff des Patentanspruchs 1.

Der Transport von Platten mit empfindlichen Oberflächen ist heikel. Dies gilt insbesondere für den Tranport von nass-beschichteten Leiterplatten von den Beschichtungs- in die Trocknungsstationen. Die Platten werden, nachdem sie mit den Leiterbahnen versehen sind, mit einem Schutzlack beschichtet; dieser wird getrocknet, belichtet und an den belichteten Stellen herausentwickelt. Dort liegt die Leiterbahn frei und kann elektrisch kontaktiert werden. Zum Beschichten wird die Platte gereinigt, vorgewärmt und auf einer Seite mit einem Schutzlack beschichtet; dann wird das Lösungsmittel evaporiert (abgelüftet) und schliesslich die Platte sum Trocknen in einen Ofen gegeben. Das gleiche Prozedere des Vorwärmens, Beschichtens, Ablüftens und Trocknens wird auch für die Beschichtung der anderen Seite angewendet. Dann wird die Platte belichtet, entwickelt und schliesslich in einem Ofen getrocknet.

Der auf automatischen Fördereinrichtungen erfolgende Transport der Leiterplatten ist insbesondere dann heikel, wenn die zweite Seite der Platte beschichtet werden soll und ganz speziell bei der Wärmebehandlung. Durch die Erwärmung ist der Lack nämlich stark aufgeweicht und ganz besonders berührungsempfindlich. Konventionelle Fördermittel, beispielsweise Förderbänder, würden die Lackschicht in unzulässiger Weise verletzen. Auflageverformung und Verschmutzungen wären die Folgen.

Eine Vorrichtung der eingangs erwähnten Art ist aus der DE-A 2 525 496 bekannt. Die Halterungen sind gegeneinander in diskreten Abständen verschiebbar. Die Abstandsverschiebung erfolgt durch an den Umlenkstationen angebrachte Steuerkurven, welche in Aussparungen an der Unterseite der einlaufenden Halterungen eingreifen. Dieses Verschiebesystem macht den Transport von unterschiedlich breiten oder getwisteten Platten, d.h. Platten, deren Lage in der Transportebene verdreht ist, praktisch unmöglich, da während der relativ langen Einlauf- und Verschiebezeit eines Halterungspaars die Steuerkurven auf einen gegebenen Abstand fixiert sind. Während dieser Zeit können keine weiteren Halterungen in die Steuerkurven einlaufen und auf einen anderen Abstand eingestellt werden. Die Halterungen werden durch federbelastete Kugeldruckstücke in Aussparungen der Querträger arretiert. Die Anpresskraft der Kugeldruckstücke erhöht die Bremskraft, die der Verschiebung der Halterungen von Aussparung zu Aussparung entgegenwirkt. Dieser unerwünschte Nebeneffekt ist eine Folge der Federkraft, mit der die Kugeldruckstücke gegen die Querträgerunterseite gedrückt werden. Die Arme jedes Querträgers sind an einem Mittelstück befestigt, welches elastische Abstützleisten zur mittigen Abstützung der zu fördernden flexiblen Materialien trägt. Diese Vorrichtung, bei der die transportierten Gegenstände mittig abgestützt werden, ist für den Transport nass-beschichteter Platten, insbesondere Leiterplatten, gänzlich ungeeignet, da dadurch die Plattenoberflächen beschädigt würden.

Bei anderen bekannten Vorrichtungen sind zwei parallel laufende Förderbänder V-förmig angeordnet, so dass die Platten nur in den Randzonen berührt werden. Der Abstand der beiden Förderbänder ist fest vorgegeben und unveränderbar. Aus diesem Grunde sind derartige Transportvorrichtungen nicht für den Transport von unterschiedlich breiten oder getwisteten Platten geeignet. Ausserdem neigen insbesondere dünne Platten zum Durchhängen und schmiegen sich an die Förderbänder, so dass ihre Lackschicht unbrauchbar wird.

Es wurden deshalb Förderbänder entwickelt, bei denen die Platten mittels auf Ketten befestigten Klammern aufgenommen und gefördert werden. Sobald jedoch Platten unterschiedlicher Breite bearbeitet werden sollen, müssen die mit den Klammern versehenen Ketten entsprechend nachgestellt werden, so dass der Arbeitsablauf ständig unterbrochen werden muss. Die Platten mit Twist, d.h. mit verdrehter Plattenfläche, wiederum müssen mit einem Führungssystem so ausgerichtet werden, dass sie in die parallel ausgerichteten Klammern eingeführt werden können. Auch ist die Haltesicherheit der Klammern nicht für alle Gewichte und Stärken der Platten in gleicher Weise gewährleistet. Hierbei ist zu berücksichtigen, dass die Stärke der Platten bei Temperaturwechseln ständig variiert. Ausserdem sind diese Klammern mit einem verhältnismässig komplizierten automatischen Klemmechanismus versehen.

Schliesslich ist noch zu erwähnen, dass Klammern bekannter Ausführungsart nach wenigen Durchgängen mit Lack verkleben.

Die Erfindung gemäss Kennzeichen des Patentanspruchs 1 beschreibt eine Vorrichtung, mit der die oben erwähnten Probleme gelöst, und Platten verschiedener Grösse, Lage und Stärke bei bestmöglicher Schonung der Oberfläche kontinuierlich transportiert werden können.

Im folgenden wird die Erfindung anhand eines in den Figuren mit Detailvarianten dargestellten Ausführungsbeispiels näher erläutert; es zeigen:

Fig. 1 die Maschine in der Aufsicht,

Fig. 2 eine Seitenansicht auf die Platteneingabestation A der Maschine in Richtung des Pfeiles I der Fig. 1,

Fig. 3 eine Ansicht in Richtung des Pfeiles III der Fig. 2,

Fig. 4 eine Seitenansicht auf die Plattenausgabestation B der Maschine in Richtung des Pfeiles IV der Fig. 1,

Fig. 5 einen Schnitt gemäss der Linie V - V der Fig. 4,

Fig. 6 eine erste Ausführungsform der Halterungen und von deren Lagerung auf den Traversen,

Fig. 7 eine Ansicht gemäss des Pfeiles VII der Fig. 6,

Fig. 8 eine zweite Ausführungsform der Lagerung der Halterungen auf den Traversen,

Fig. 9 eine Ansicht gemäss des Pfeiles IX der Fig. 8,

Fig. 10 eine Detailvariante zu Fig. 8 und

Fig. 11 eine Ansicht gemäss des Pfeiles XI der Fig. 10.

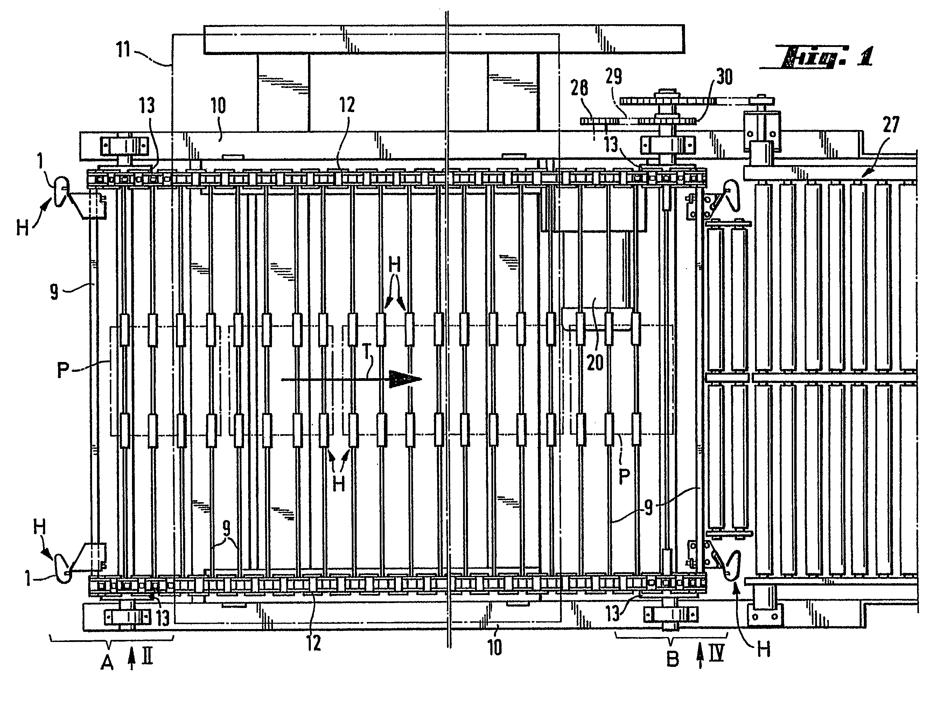

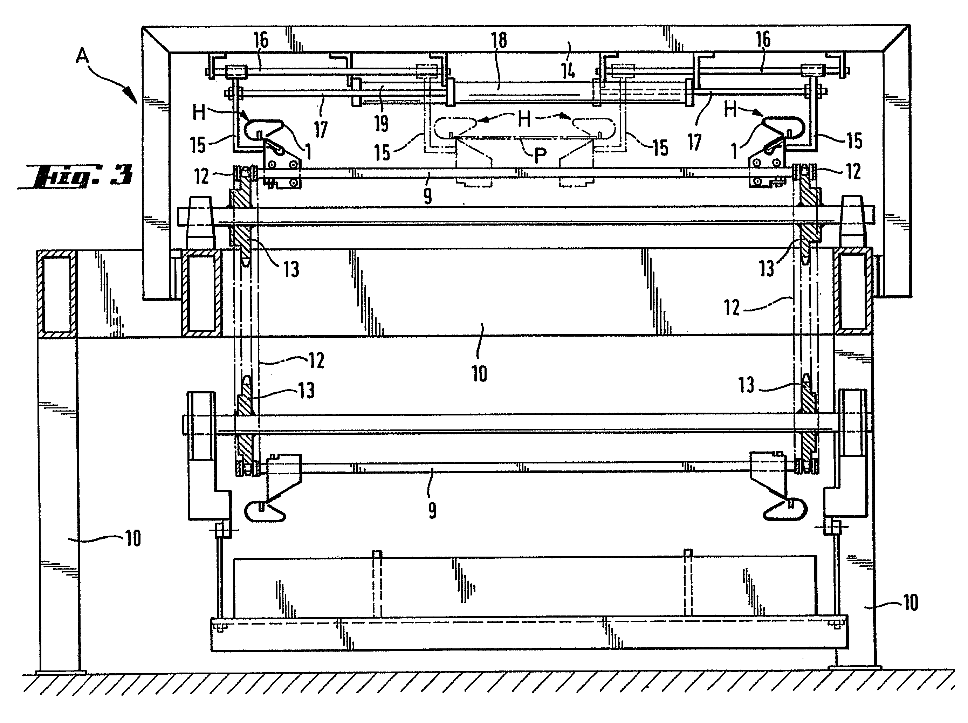

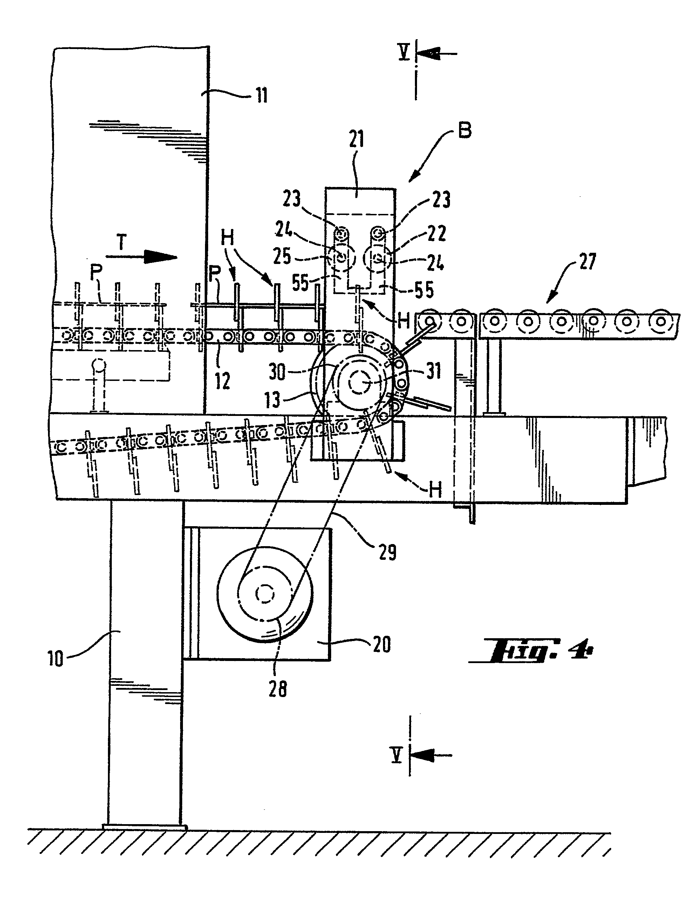

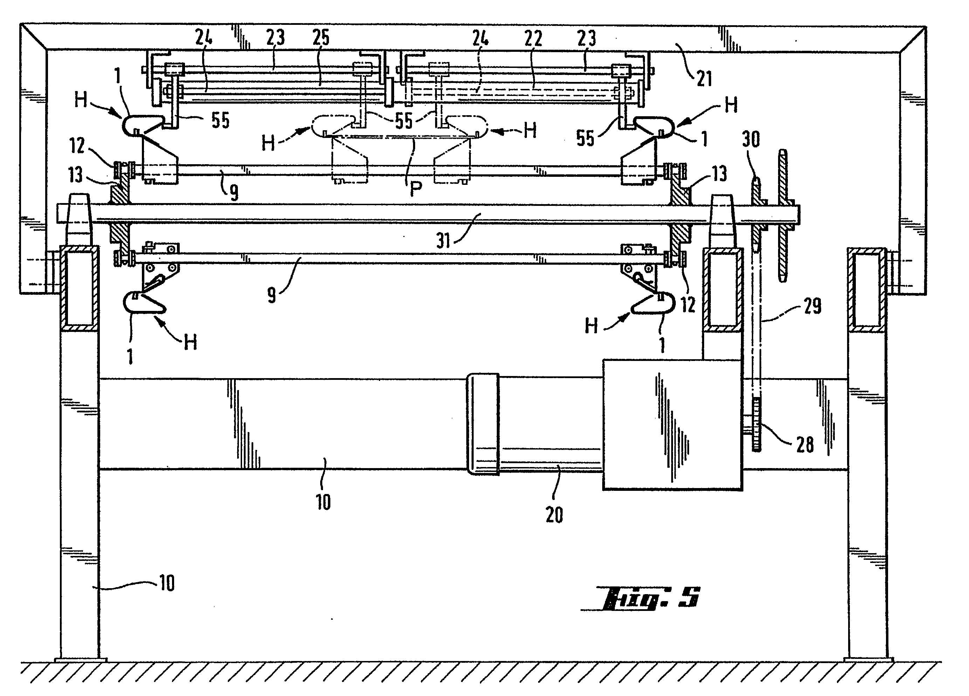

Die Maschine ist mit Förderbändern 12 ausgestattet, welche in Richtung des Pfeiles T umlaufen (Fig. 1). Der Antrieb erfolgt mittels eines Motors 20, welcher über einen Seil-, Riemen- oder Kettentrieb 28, 29, 39 eine Welle 31 mit Umlenk- und Antriebsrollen 13 die Förderbänder 12 antreibt (Fig. 5). Auf den Förderbändern 12 sind in regelmässigen Abständen Traversen 9 montiert. Auf jeder dieser Traversen 9 sind je zwei Halterungen H für die zu transportierenden Platten P verschiebbar angeordnet.

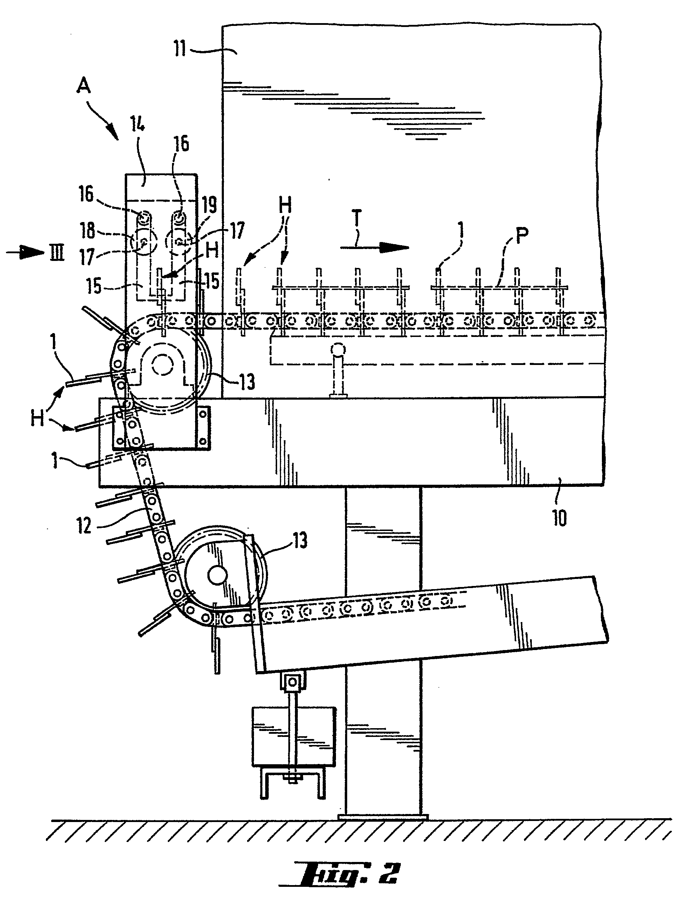

In der Station A (Fig. 2, 3) werden die Platten von den Halterungen H erfasst und durch eine Behandlungsstation (unter der Abdeckhaube 11, beispielsweise in Form eines Trocknungsofens) zur Station B (Fig. 4, 5) transportiert, wo die Halterungen H automatisch geöffnet und die behandelten Platten P mittels eines Rollenförderers 27 abtransportiert werden. Die Halterungen H müssen jede eine Bremseinrichtung enthalten.

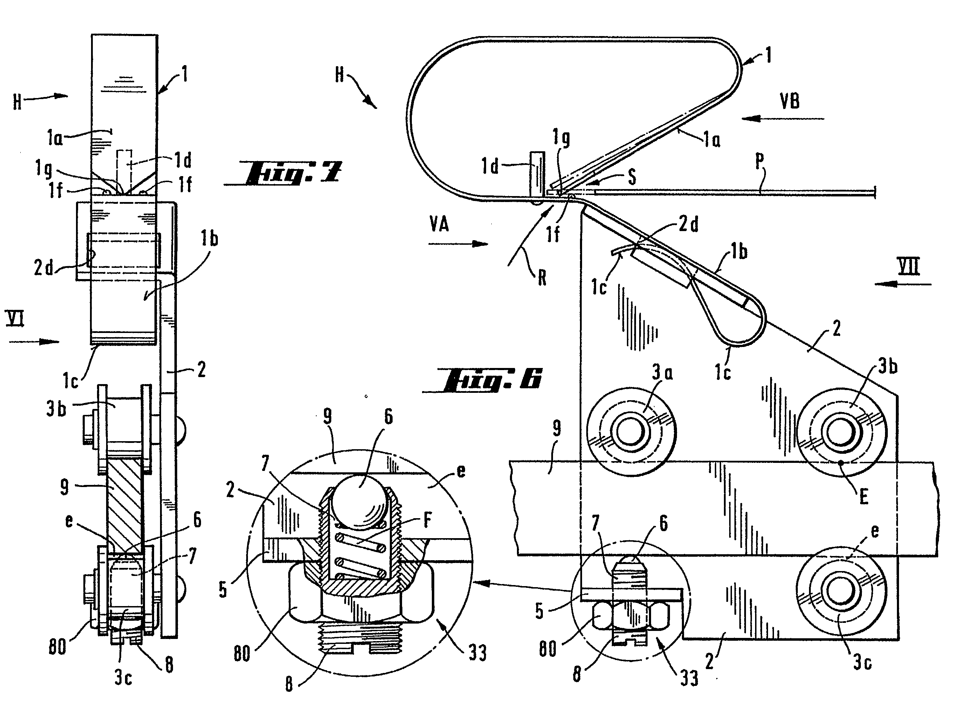

Bevor auf die Funktion der Maschine näher eingegangen wird, sollen zunächst die Halterungen H und deren Lagerung auf den Traversen 9 anhand der in den Fig. 6 und 7 bzw. 8 und 9 dargestellten Ausführungsformen näher beschrieben werden.

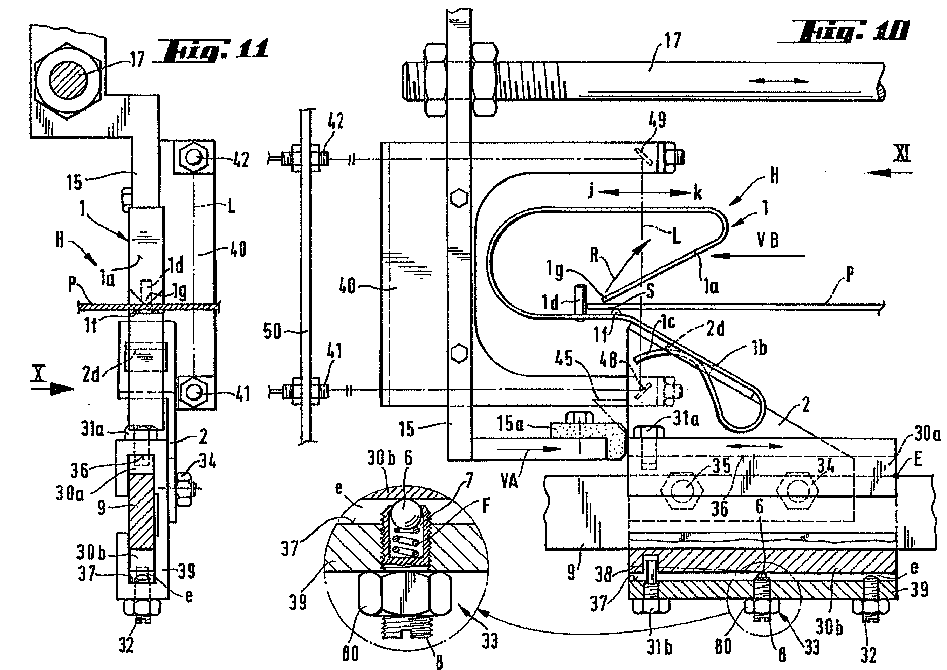

Gemäss den Ausführungsbeispielen der Fig. 6 und 7 bzw. 8 und 9 bzw. 10 und 11 sind die Halterungen H mit Klemmfedern 1 ausgestattet, welche mittels Supports 2 verschiebbar auf den Traversen 9 gelagert sind. Die Klemmfedern 1 sind darstellungsgemäss durch Blattfedern gebildet. Diese sind so geformt, dass sie ein nach innen offenes V bilden, welches am Schnittpunkt der Schenkel 1a, 1b einen federnden Klemmschlitz S zur Aufnahme der Platten P bildet. Der obere V-Schenkel 1a ist nach hinten und dann bügelförmig nach unten und zurück zum V-Schlitz gebogen und verläuft anschliessend zur Bildung des unteren V-Schenkels 1b schräg nach unten. Der untere Schenkel 1b weist einen Fortsatz 1c auf der so geformt ist, dass er in eine entsprechende Ausnehmung 2d des Supports 2 einrasten kann und die Blattfeder mit diesem fest verbindet. Hinter dem Klemmschlitz S befindet sich ein Anschlag 1d für die Platten P. Im Bereich des Klemmschlitzes S endet der obere Blattfederschenkel 1a in einer Spitze 1g (Fig. 6, 10). In Platteneinschubrichtung unmittelbar hinter dem Klemmschlitz S ist die Blattfeder mit nach innen ragenden Nocken 1f versehen. Diese Nocken 1f bzw. Spitze 1g bewirken eine punktuelle Berührung der Platten P und damit eine sowohl bezüglich Haltekraft und Plattenschonung verbesserte Wirkung.

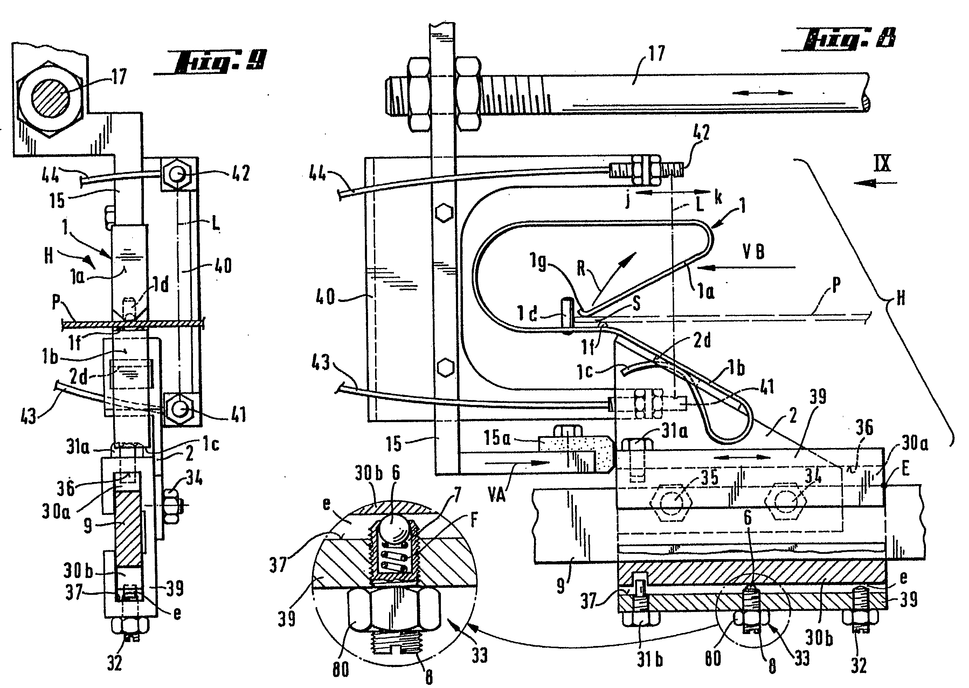

Der obere V-Schenkel der die Halterung bildenden Blattfeder 1 kann wie in Fig. 6 und 10 dargestellt spitz im Klemmschlitz S enden oder wie in Fig. 8 gezeigt, nach innen umgebogen sich noch ein Stück weit fortsetzen.

Im Ausführungsbeispiel der Fig. 6 und 7 ist der Support 2 mittels Rollen 3a, 3b und 3c auf der Traverse 9 gelagert. Ein auf einem Winkelansatz 5 am unteren, auswärts gerichteten Ende des Supports montierten Federmechanismus presst eine Kugel 6 mittels einer im Zylinder 7 befindlichen Feder F auf die Traverse 9 und zieht die Rollen 3a und 3b bremsend gegen die Oberseite derselben. Der Federdruck und damit die Anpresskraft sind durch die Schraube 8 einstellbar. Desgleichen ist durch die Wahl der Einschraubtiefe des Zylinders 7, welcher in der gewünschten Lage durch eine Kontermutter 80 blockierbar ist, die Anschlagposition fein einstellbar. Infolge dieser Anordnung und eines ausreichenden Spiels e der Rollenlagerung ist der Support 2 mit der Platten-Klemmfeder 1 aus der dargestellten Lage gegen die Wirkung der Feder F im Uhrzeigersinn begrenzt schwenkbar (Pfeil R). Die Schwenkachse E liegt dabei an der Rolle 3b auf der Traversenoberseite und verläuft parallel zur Achse dieser Rolle.

Das Verhältnis der als Hebel wirksamen Abstände zwischen Schwenkachse und Plattenklemmschlitz S einerseits und Schwenkachse und Angriffstelle der federbelasteten Kugel 6 an der Unterseite der Traverse 9 anderseits ist so gross, dass die Schwenkamplitude des Klemmschlitzes bis zu einem Vielfachen der Schwenkamplitude des Supports an der federbelasteten Kugel 6 betragen kann.

Die federbelastete Kugel 6 wirkt auch als Verschiebebremse. Anstelle der Kugel kann auch ein flächiges auf die Traverse 9 wirkendes Anschlags- und Bremselement treten. Die Feder F dient einerseits als Rückstellfeder für den Schwenkmechanismus und anderseits als Bremsfeder.

Die Ausführungsform der Fig. 8 und 9 bzw. 10 und 11 unterscheidet sich von derjenigen der Fig. 6 und 7 durch die Art der Lagerung des Supports 2 an der Traverse 9. Die Lagerung erfolgt hier mittels Gleitkufen 30a und 30b in einem Gleitkufenträger 39, welcher mittels Schrauben 34 und 35 fest am Support 2 angeschraubt ist und welcher oben und unten je eine Ausnehmung 36, 37 zur Aufnahme der Gleitkufen 30a bzw. 30b aufweist. Die Gleitkufen 30a bzw. 30b sind gegen Längsverschiebung durch Schrauben 31a bzw. 31b gesichert. Die darstellungsgemäss untere Kufe 30b liegt auf zwei Anschlägen, von denen der eine durch eine Stellschraube 32 zum Einstellen des Speils e und der andere durch einen bezüglich Anschlaghöhe und Federkraft wahlweise einstellbaren (justierbaren) Federmechanismus 6, 7, 8, 80, F (wie anhand der Fig. 6 beschrieben) gebildet ist. Zwischen der Unterseite der Gleitkufe 30a und dem diese untergreifenden Boden der Ausnehmung 37 ist das obenerwähnte Spiel e vorhanden. Der Support 2 und damit der Klemmschlitz S für die Platten P sind daher (wie in Fig. 6) gegen die Kraft der Feder F (Rückstellfeder) im Uhrzeigersinn begrenzt schwenkbar (Pfeil R). Der Betrag der Schwenkung des Supports 2 um die Schwenkachse E, die am einwärtigen Ende des Supports 2 im Bereich der oberen Gleitkufe 30a, vorzugsweise an deren Endkante auf der Oberseite des Supports liegt, ist durch das darstellungsgemäss obere Ende der Rückstelleinrichtung 33 festgelegt und verläuft senkrecht zur Traverse 9 und parallel zur Einspannebene der Platten P. Auch hier (wie in Fig. 6) ist die Schwenkamplitude des Klemmschlitzes S bis zu einem Vielfachen grösser als die Schwenkamplitude an der Feder F. Die Feder F drückt die Kufe 30b mehr oder weniger stark auf die Traverse 9 bzw. deren Unterseite, wodurch die erforderliche Bremskraft erzeugt wird.

Um einen ausreichenden Schwenkweg (gemäss Pfeil R) zu ermöglichen, kann die dem Nutengrund der Nut 37 gegenüberliegende Seite der Gleitkufe 30b, wie in Fig. 10 bei 38 angedeutet, abgeschrägt sein.

Eine die Schwenkbewegung (Pfeil R) unterstützende, mit dem Stössel 15 zusammenwirkende Nocke 45 kann, wie in Fig. 10 angedeutet, vorgesehen sein.

In der Fig. 6, 7 bzw. 8, 9 bzw.10, 11 sind jeweils die "linken" Halterungen dargestellt. Die "rechten" Halterungen sind bezüglich ihren Funktionen spiegelbildlich gleich. So entspricht z.B. einem Schwenken der linken Halterungen im Uhrzeigersinn ein Schwenken der rechten Halterungen entgegen dem Uhrzeigersinn.

Gemäss den Fig. 6, 7 bzw. 8, 9 bzw. 10, 11 sind die Halterungen bzw. Supports 2 gebremst verschiebbar und gegen die Kraft einer Rückstellfeder F begrenzt schwenkbar auf den Traversen 9 gelagert. Dies ermöglicht eine relativ einfache und betriebssichere Konstruktion. Grundsätzlich können jedoch die Verschiebe- und Schwenkfunktionen voneinander getrennt, d.h. der Support selbst mit einem Gelenk und einer Rückstellfeder ausgebildet werden.

Sinn und Zweck der Schwenkbarkeit der Halterungen werden weiter unten ausführlich erläutert.

Wie aus den Fig. 2 und 3 ersichtlich, umfasst in der Beladestation A der Mechanismus zur Steuerung der Halterungen zum Erfassen und Festhalten der Platten P einen an einem Rahmen 14 montierten pneumatischen Zylinder 18, mit eine mit Kolben (nicht gezeigt), mittels welchem über eine Kolbenstange 17 von einer Führungsstange 16 geführte Stössel 15 hin- und herbewegt werden.

In den Fig. 8 und 10 ist jeweils einer der Stössel 15 und ein Stück der Kolbenstage 17 zu sehen. Die Stössel sind etwa L-förmig und mit Anschlägen 15a aus stossdämpfendem Material versehen.

Wie Fig. 3 mit gestrichelter Linie zeigt, wird eine Leiterplatte P von einem Paar Halterungen H-H an ihren seitlichen Rändern festgeklemmt. Zu diesem Zweck werden die paarigen Halterungen auf die seitlichen Plattenränder aufgeschoben. Dies geschieht automatisch mittels der seitlich auf einer Führungsstage 16 angeordneten Stössel 15. Der Zylinder 18 für den Antrieb des linken Stössels 15 verdeckt in Fig. 3 teilweise den für den rechten Stössel 15 vorgesehenen Zylinder 19. Dieser ist in der Fig. 2 gezeigt. Vom Antrieb des rechten Stössels 15 ist in Fig. 3 lediglich ein Teil der Führungsstange 16 und der Kolbenstange 17 sichtbar. In ihrer Eingriffstellung an der Platte P sind die Stössel 15 in Fig. 3 gestrichelt gezeigt.

Die in vorgegebenen Abständen von je nach Maschinengrösse ca. 20 bis 100 mm parallel zueinander angeordneten Traversen 9 werden von den seitlichen Förderbändern 12 über den Fördertisch 10 geführt. Die Zuführung der Förderbänder 12 mitsamt den Traversen 9 und Halte rungen H erfolgt über Umlenkrollen 13. Sobald eine Traverse 9 zwischen den beiden Stössel 15 in der Station A eintrifft, werden die noch seitlich stehenden Halterungen H von den Stösseln 15 gegen die Traversenmitte geschoben. Die Platten P werden von in der Figur nicht dargestellten Fördermitteln, beispielsweise von Förderrollen, in Höhe der Klemmschlitzes der Halterungen H parallel zur Ebene des Fördertisches 10 zugeführt. Sobald eine Platte P in den Bereich der Stössel 15 in die Vorrichtung hineinragt, schieben die Stössel 15 zwei Halterungen H auf die Plattenränder seitlich auf, welche sich dort automatisch festklemmen.

Wie aus den Fig. 8 und 9 ersichtlich, ist die Aufschubbewegung der Stössel 15 durch eine mittels eines Bügels 40 fest mit dem Stössel 15 verbundene Lichtschranke 41/L/42 gesteuert. In der Variante gemäss Fig. 8 gelangt das Licht über einen Lichtleiter 43 zum Emitter 41 und das von diesem abgestrahlte Licht L zum Empfänger 42 und von dort über einen Lichtleiter 44 in eine Auswertungsschaltung (nicht dargestellt), welche ihrerseits den pneumatischen Stösselantrieb steuert. Die Steuerung erfolgt derart, dass, wenn eine Platte P mit ihrer in Einschubrichtung vorderen Kante den Lichtstrahl L unterbricht, der pneumatische Antrieb der Stössel gestoppt und umgesteuert und die Stössel nach aussen zurückgezogen werden. Die Lichtschranke 41/L/42 bzw. deren Sender 41 und Empfänger 42 sind in Richtung der Doppelpfeile j-k verschiebbar, wodurch die Lichtschranke insbesondere entsprechend der Plattendicke und damit entsprechend dem Widerstand, den die Klemmfeder 1 zum Aufschieben auf den Plattenrand überwinden muss, so einstellbar ist, dass die Einschiebebewegung unmittelbar vor Kontakt des Plattenrandes mit dem Anschlag 1d beendet wird oder dass die Platte nur mit stark reduzierter Geschwindigkeit auf diesen Anschlag auftrifft.

Bei der Variante gemäss Fig. 10 und 11 sind die Lichtleiter durch Umlenkspiegel 48 und 49 ersetzt. Die Spiegel 48 und 49 sitzen an den selben Stellen wie in Fig. 8 und 9 Emitter und Empfänger. Hingegen sind Emitter 41 und Empfänger 42 auf einem feststehenden Maschinen teil 50 montiert. Die Umlenkspiegel 48 und 49 sind zur Einstellung und Justierung der Lichtschranke L in Richtung der Doppelpfeile j-k verschiebbar.

Aus zeichnerischen Platzgründen ist in Fig. 10 der Abstand zwischen dem ortsfesten Maschinenteil 50 und der Halterung bzw. dem Stössel 15 relative klein. Tatsächlich ist dieser Abstand wesentlich grösser.

Auf die vorangehend beschriebene Weise werden die Platten P, welche mit gleicher Geschwindigkeit zugeführt werden wie das Förderband 12 sich bewegt, in regelmässigen Abständen seitlich von den Halterungen H erfasst und von den Förderbändern über den Fördertisch 10 und durch die Behandlungsstation und in die Entladestation B getragen.

Am Ende des Transportweges werden in der Station B (Fig. 1, 4, 5) die Halterungen H automatisch geöffnet, und die behandelten Platten gelangen zum Weitertransport auf die Rollenstrasse 27. Der Mechanismus zum Oeffnen der Halterungen ist analog aufgebaut wie derjenige zum Schliessen (Station A). In der Station B werden die Halterungen H mittels Stösseln 55 gegen die äusseren Enden der Traversen 9 zurückgeschoben. Dadurch werden die Halterungen H von den Leiterplatten P abgezogen. Hierbei kontaktiert der gegen die Halterung gerichtete Teil des Stössels 55 den oberen Teil eines Klemmschenkels 1a, so dass dieser zuerst federnd nach oben zurückgedrückt wird und damit die Leiterplatte P freigibt, bevor die Halterung H als ganzes auswärts verschoben und abgezogen wird. Die Einwirkung des Stössels 55 zum Oeffnen der Klemme und Abziehen der Halterung ist in den Fig. 6 und 8 jeweils durch den Pfeil VB angedeutet.

Der Antrieb erfolgt auch hier von einem pneumatischen Zylinder 22, der an einem Halterahmen 21 oberhalb der Förderebene der Platten P befestigt ist. Einer der Stössel 55 ist auf einer Führungsstange 23 geführt und mit einer zum Kolben (nicht gezeigt) im Zylinder 22 führenden Kolbenstange 24 verbunden. In Ruhestellung befinden sich die Stössel 55, wie gestrichelt gezeigt, im Bereiche der Traversenmitte in Erwartung einer neuen Platte P. Aus Gründen der Uebersichtlichkeit ist wiederum der Zylinder 22 für den linken Stössel 55 vorne liegend eingezeichnet, und verdeckt grösstenteils den Zylinder 25 für den rechten Stössel 55, der in der Seitenansicht gemäss Fig. 4 im Schnitt neben dem Zylinder 22 gezeigt ist.

Wie weiter oben anhand der Fig. 6 und 7 bzw. 8 und 9 bzw. 10 und 11 im Detail erläutert, sind die Halterungen H mit ihren Supports 2 auf den Traversen 9 gebremst verschiebbar und gleichzeitig gegen die Kraft einer Rückstellfeder F nach innen verschwenkbar gelagert. Die Verschiebestössel 15 wirken oberhalb der Schwenkachse E auf die Halterungen ein. Diese Einwirkung des Stössels 15 auf die Halterung H ist in den Fig. 6, 8 und 10 jeweils durch den Pfeil VA angedeutet. Dieser Mechanismus ist nun so abgestimmt bzw. abstimmbar, dass die Kraft der Schwenk-Rückstellfeder F einerseits kleiner als die Bremskraft zwischen Halterung und Traverse und anderseits grösser als die Wirkung des Gewichtes der zu transportierenden Platte ist. Infolge dieser Abstimmung und des Angriffspunktes der Stössel werden in der Einspannstation A die Halterungen H beim Verschieben durch die Stössel 15 gegen die Wirkung der Rückstellfeder F nach innen geschwenkt (Pfeil R). Nach dem Einklemmen der Platten bzw. wenn deren Einspannrand an den Anschlag 1d der Klemmfeder 1 gelangt und ab Beginn der Rückbewegung der Stössel haben die Halterungen infolge der Kraft der Rückstellfeder F die Tendenz zum Zurückschwenken. Hierdurch üben sie auf die eingespannte Platte eine Zugspannung aus, und wirken dadurch einer unerwünschten Durchbiegung der Platte entgegen. Da je nach Seitenlänge der Platten gleichzeitig auf jeder Seite mehrere Halterungen auf die Platte einwirken, kann diese Zugspannung relativ gross und daher sehr wirkungsvoll sein.

Ein weiterer Vorteil ergibt sich aus dem Druck des Plattenrandes gegen den V-Schenkel 1a und daraus, dass der letztere bereits in Schwenkstllung ist; der Anschlagwinkel zwischen dem Plattenrand und dem oberen V-Schenkel 1a wird hierdurch kleiner und das Anheben des V-Schenkels durch den Plattenrand geschieht glatt und nicht abrupt, wie dies der Fall wäre, wenn der obere V-Schenkel 1a nicht schwenkbar wäre. Die Dämpfung des Kontakts zwischen dem Plattenrand und der äusseren Flanke des V-Schenkels 1a ist von besonderem Vorteil, wenn der Plattenrand leicht nach aufwärts gebogen wird, was eintritt, wenn der mittlere Bereich der Platte unter deren Eigengewicht leicht nach unten durchhängt, während die Platte an der Beladestation A eintrifft.

Der Schwenkbogen, den der Schlitz S durchläuft, ist dann ein vielfaches des vom oberen Rand des Zylinders 7 beschriebenen Bogens, wenn dieser Zylinderrand selber an der Unterseite des Supports 2 bzw. der unteren Gleitkufe 30b beim Schwenken anschlägt (Fig. 3 bzw. Fig. 8). Dies ist dann sichergestellt, wenn der Zylinder 7 genügend weit über die Oberfläche des Winkels 5 oder über den Boden der Ausnehmung 37 des unteren Teils des Gleitkufenträgers 30 hinaufragt. Andererseits kann in letzterem Falle und die nach auswärts zu liegende Bodenzone der Gleitkufe 30b nach aufwärts abgeschrägt sein, um zu verhindern, dass die am auswärts gerichteten Ende liegende Bodenkante der Ausnehmung 37 gegen die Unterseite der Gleitkufe 30b anschlägt, bevor der Rand des Zylinders 7 dies tun kann (abgeschrägte Unterseitenzone 38, in Fig. 10 strichpunktiert angedeutet).

Das einwärts gerichtete Schwenken der Halterungen H tritt automatisch nur ein, solange das Niveau der Berührung zwischen dem Stössel 15 und dem oberen Bereich des Supports 2 der betreffenden Halterung H genügend hoch über dem Niveau der Schwenkachse E liegt, so dass die auf den Support 2 einwirkende Bremskraft des Bremselements, also in den Ausführungsformen nach Figuren 6 bis 11 die Rückstellfeder F, oder gegebenenfalls ein anderes von der Rückstellfeder getrenntes Bremsorgan stärker ist, als die nach innen gerichtete Schubkraftkomponente, wobei die Schubkraft zunächst zum Schwenken gegen die Kraft der Rückstellfeder aufgewendet wird. Nur wenn die Schwenkung bis zu ihrer Grenze stattgefunden hat, gelangt die volle Schubkraft zum Einsatz, um die Bremskraft zu überwinden. In Fig. 6 deutet der Pfeil Va nicht nur die Richtung, sondern auch das Niveau an auf welchem der Stössel am Support 2 angreift. Greift jedoch der Stössel 15, wie dies in den Ausführungsformen nach Figuren 8 bis 11 gezeigt ist, am Support 2 nur geringfügig oberhalb des Niveaus der Schwenkachse E an (wobei die Schwenkkomponente der Stösselschubkraft kleiner werden kann als die Kraft der Rückstellfeder), so kann das Schwenken der Halterung H durch die Vorkehrung eines Nockenstücks 45 an der auswärtigen Endfläche des Supports 2 sichergestellt werden, wobei die Unterseite des Nockenstücks 45 so konkav ausgebildet sein kann, dass sie das Anschlagende des Stössels 15 in jedem Fall veranlasst, die gesamte Halterung in Richtung des Pfeiles R zu schwenken; wird die Einwärtsbewegung des Stössels 15 wegen Eindringen des Plattenrandes in die Lichtbarriere 41/L/42 oder 48/L/49 (Fig. 8 oder 10) gestoppt oder reversiert, so löst der Stössel 15 sich vom Nockenstück 45, und die Rückstellfeder S kann die Halterung H in ihre Ausgangsstellung zurückdrücken.

Die Kurvennase 45 ist auch im Falle des in Fig. 8 und Fig. 10 gezeigten Niveaus des Stössels 15 nicht erforderlich, wenn die Rückstelleinheit 33 im oberen Bereich des Gleitkufenträgers 30 vorgesehen ist, und so die Gleitkufen 30a und 30b gegen die Ober- und Unterseite der Traverse 9 drückt, während das Spiel e hierbei zwischen der oberen Endfläche der Kufe 30a und dem darüber liegenden Boden der oberen Ausnehmung 36 gebildet wird. In diesem Falle liegt die Schwenkachse E diametral gegenüber der in den Figuren 8 und 10 gezeigten. Der Schwenkvektor der Schubkraft des Stössels 15 sollte dann grösser sein als die Rückstellkraft der Rückstellfeder F, sodass das Schwenken der Halterung H auch ohne das Vorhandensein der Nase 45 erfolgt. Jeddoch kann die Unterbringung der Rückstelleinheit 33 auf der Oberseite des Gleitkufenträgers 30 Raumprobleme mit sich bringen, so dass die in Figuren 8 bis 11 gezeigte Anordnung der Rückstelleinheit 33 bevorzugt wird.

## Patentansprüche

1. Vorrichtung zum Transport von Platten, insbesondere von nass beschichteten Leiterplatten, mit an umlaufenden Bändern, Seilen, Ketten oder dergleichen befestigten Querträgern, auf welchen je zwei Halterungen (H) gegen die Bremswirkung von zusätzlichen, die normale Haftreibung erhöhenden Mittels gegeneinander verschiebbar gelagert sind, wobei in einer Beladestation (A) Mittel zum Zusammenschieben und Schliessen der Halterungen (H) und in einer Entladestation (B) Mittel zum Öffnen und Auseinanderschieben der Halterungen (H) während des Durchlaufes angeordnet sind, dadurch gekennzeichnet, dass
   — die Querträger als zwei Bänder, Seile, Ketten oder dergleichen verbindende Traversen (Q) ausgebildet sind, wobei auf den Traversen (9) die Strecke zwischen den Halterungen (H) frei von zusätzlichen Stützmitteln für die Platten ist,
   — die Verschiebbarkeit der Halterungen durch die zusätzlichen Mittel kontinuierlich so stark gebremst ist, dass die Halterungen (H) an jedem Ort ihres Verschiebeweges allein durch die Bremskraft ausreichend fixiert sind und
   — die Mittel zum Schieben, Schliessen und Öffnen der Halterungen (H) Stössel (15 bzw. 55) umfassen.

2. Vorrichtung nach Anspruch 1, dadurch gekennzeichnet, dass die Halterungen (H) gegen die Wirkung einer Rückstellfeder (F) nach innen schwenkbar sind, so dass nach Aufnahme einer Platte (P) auf diese eine Durchbiegungen reduzierende Zugspannung ausgeübt wird.

3. Vorrichtung nach Anspruch 1 oder 2, dadurch gekennzeichnet, dass die Stössel (15 bzw. 55) mit je einem in der Belade- und Entladestation (A bzw. B) ortsfest, oberhalb der Umlaufbahn der Halterungen (H) angeordneten Antrieb (18, 19, 22, 24) verbunden sind.

4. Vorrichtung nach Anspruch 2 und 3, dadurch gekennzeichnet, dass in der Beladestation (A) die Stössel (15) oberhalb der Schwenkachse (E) der Halterungen (H) angreifen und dass die Kraft der Schwenk-Rückstellfeder (F) einerseits kleiner als die Bremskraft ist, mit welcher die Halterungen auf den Traversen (9) gelagert sind, und anderseits grösser ist als die Wirkung des Plattengewichts.

5. Vorrichtung nach einem der vorangehenden Ansprüche, dadurch gekennzeichnet, dass die Halterungen (H) durch eine Federklemme mit in nach innen offener V-Form angeordneten Klemmschenkel (1a, 1b) gebildet ist, welche in ihrem Schnittpunkt einen Klemmspalt (S) zum Einschieben der Platten (P) freilassen.

6. Vorrichtung nach Anspruch 5, dadurch gekennzeichnet, dass die Federklemme mit den Klemmschenkel (1a, 1b) einstückig durch eine entsprechend geformte Blattfeder (1) gebildet ist.

7. Vorrichtung nach Anspruch 5 oder 6, dadurch gekennzeichnet, das in der Enladestation (B) die Stössel (55) am oberen Klemmschenkel (1a) angreifen, so dass am Beginn des Auseinanderschiebens die Federklemme nach Massgabe der Differenz zwischen der Schiebekraft der Stössel und der Bremskraft, mit welcher die Halterung auf der Traverse gelagert ist, geöffnet wird.

8. Vorrichtung nach einem der Ansprüche 2 bis 7, dadurch gekennzeichnet, dass die Mittel zur zusätzlichen Bremsung der Haltemittel (H) auf den Traversen (9) als Bremselement (6, 30b) ausgebildet sind, welches mittels einer Feder (F) gegen die Traverse (9) gepresst wird, und welches so angeordnet ist, dass die Feder gleichzeitig die Schwenk-Rückstellfeder (F) bildet.

9. Vorrichtung nach Anspruch 8, dadurch gekennzeichnet, dass der Abstand zwischen der Schwenkachse der Halterung (H) und der Platteneinspannebene einerseits und derjenige zwischen Schwenkachse (E) und oberem Ende der Rückstelleinheit (33) andererseits eine solche Hebelübersetzung bildet und die Rückstellfeder (F) an einer solchen Stelle angeordnet ist, dass der Schwenkweg (Schwenkamplitude) an der Platten-Einklemmstelle (Klemmschlitz S) ein Vielfaches des Rückstellfederweges beträgt.

10. Vorrichtung nach einem der Ansprüche 2 bis 9, dadurch gekennzeichnet, dass die Halterungen (H) auf Supports (2) sitzen, die mittels Rollen (3a, 3b, 3c) und einem federbelasteten Bremsele ment (6) begrenzt schwenkbar auf den Traversen (9) gelagert sind, wobei das Bremselement so angeordnet ist, dass die Bremsfeder (F) gleichzeitig die Schwenk-Rückstellfeder (F) bildet.

11. Vorrichtung nach einem der Ansprüche 2 bis 9, dadurch gekennzeichnet, dass die Halterungen auf Supports (2) sitzen, die mittels gegen Längsverschiebung und seitliches Ausweichen gesicherten Gleit- und Bremskufen (30a, 30b) auf den Traversen (9) gelagert sind, wobei zur Bildung des Schwenk- und Bremsmechanismus mindestens eine dieser Kufen (30b) federnd schwenkbar (Feder F) gegen die Traverse gedrückt ist.

12. Vorrichtung nach einem der vorangehenden Ansprüche, dadurch gekennzeichnet, dass die Halterungen (H) im Klemmbereich Nocken (lf) aufweisen, so dass dort eine Berührung der Platten (P) nur punktuell erfolgt.

13. Vorrichtung nach einem der vorangehenden Ansprüche, dadurch gekennzeichnet, dass jeder Stössel 15 der Beladestation (A) mit einer die Einschubtiefe der Platten (P) abtastenden Lichtschranke (41-L-42) ausgestattet ist, welche bei Detektion einer Plattenkante den pneumatischen Antrieb des Verschiebestössels (15) stoppt bzw. reversiert.

## Claims

1. An apparatus for conveying panels, in particular wetcoated circuit boards, having transverse organs attached to circumferential belts, ropes, chains or the like, on which transverse organs two holding devices (H) are mounted in each case so as to be reciprocally displaceable against the braking effect of additional means increasing the normal static friction, means for drawing together and closing the holding devices (H) being arranged in a charging station (A) and means for opening and separating the holding devices (H) during passage being arranged in an discharging station (B), characterised in that

– the transverse organs are constructed as cross ties (Q) connecting two belts, ropes, chains or the like, the section on the cross ties (9) between the holding devices (H) being free of additional support means for the panels,
– the travel of the holding devices (H) is continuously braked so strongly by the additional means that the holding devices (H) are adequately fixed at any point on their path of displacement by the braking force alone, and
– the means for pushing, closing and opening the holding devices (H) comprise pusher members (15 or 55).

2. An apparatus according to Claim 1, characterised in that the holding devices (H) can be pivoted inwards against the action of a restoring spring (F) so that after receiving a panel (P) a tensile stress which reduces sagging is exerted thereon.

3. An apparatus according to Claim 1 or 2, characterised in that the pusher members (15 or 55) are connected to one fixed drive (18, 19, 22, 24) each arranged in the charging and discharging stations (A or B) above the revolving path of the holding devices (H).

4. An apparatus according to Claims 2 and 3, characterised in that in the charging station (A) the pusher members (15) engage above the swivel axis (E) of the holding devices (H) and that the force of the tilt-biasing and restoring spring (F) on one hand is smaller than the braking force with which the holding devices are mounted on the cross ties (9), and on the other hand is greater than the effect of the weight of the panel.

5. An apparatus according to one of the preceding Claims, characterised in that the holding devices (H) are formed by a clamping spring having clamping legs (1a, 1b) which are arranged in a V-shape which opens inwards, and which leave free a gripping slot (S) for insertion of the panels (P) at their point of intersection.

6. An apparatus according to Claim 5, characterised in that the clamping spring with the clamping legs (1a, 1b) is formed in one piece by a suitably shaped leaf spring (1).

7. An apparatus according to Claim 5 or 6, characterised in that the pusher members (55) engage the upper clamping leg (1a) in the discharging station (B), so that at the beginning of separation the clamping spring is opened to a degree depending on the difference between the pushing force of the pusher members and the braking force with which the holding device is mounted on the cross tie.

8. An apparatus according to one of Claims 2 to 7, characterised in that the means for additional braking of the holding means (H) on the cross ties (9) are constructed as braking elements (6, 30b) which are pressed against the cross tie (9) by means of a spring (F) and which are arranged so that the spring at the same time forms the tilt-biasing and restoring spring (F).

9. An apparatus according to Claim 8, characterised in that the distance between the swivel axis of the holding device (H) and the panel gripping plane on one hand and the distance between the swivel axis (E) and the upper end of the restoring unit (33) on the other hand form such a lever transmission and the restoring spring (F) is arranged at such a point that the tilting stroke (tilting amplitude) on the panel gripping point (gripping slot S) is a multiple of the path of the restoring spring.

10. An apparatus according to one of Claims 2 to 9, characterised in that the holding devices (H) are seated on supports (2) which are mounted on the cross ties (9) so as to be limitedly pivotable by means of rollers (3a, 3b, 3c) and a spring-loaded braking element (6), the braking element being disposed so that the braking spring (F) at the same time forms the tilt-biasing and restoring spring (F).

11. An apparatus according to one of Claims 2 to 9, characterised in that the holding devices are seated on supports (2) which are mounted on the cross ties (9) by means of sliding and braking runners (30a, 30b) which are secured against longitudinal displacement and lateral yielding, at least one of said runners (30b) being pressed resiliently pivotally (spring F) against the cross tie to form the pivoting and braking mechanism.

12. An apparatus according to one of the preceding Claims, characterised in that the holding devices (H) in the region of clamping have nipples (1f) so that contact of the panels (P) only takes place there at points.

13. An apparatus according to one of the preceding Claims, characterised in that each pusher member (15) of the loading station (A) is equipped with a light barrier (41-L-42) which scans the depth of penetration of the panels (P), which barrier stops or reverses the pneumatic drive of the displacement pusher member (15) upon detecting a panel edge.

## Revendications

1. Convoyeur pour plaques, en particulier pour plaquettes de circuits imprimés encore humides d'enduction, comprenant des entretoises transversales qui sont fixées à des bandes, câbles, chaînes ou analogues tournantes et sur lesquelles deux fixations (H) sont respectivement montées déplaçables l'une par rapport à l'autre à l'encontre de l'effet de freinage de moyens supplémentaires augmentant le frottement normal par adhérence, des moyens pour rapprocher l'une de l'autre et pour fermer les fixations (H) étant installés dans un poste de chargement (A) et des moyens pour ouvrir et écarter les fixations (H) l'une de l'autre pendant leur passage étant installé dans un poste de déchargement (B), caractérisé par le fait que:

– les entretoises transversales sont réalisées sous la forme de traverses (Q) reliant deux bandes, câbles, chaînes ou analogues, le tronçon situé entre les fixations (H), des traverses (9) étant exempt de moyens support supplémentaires pour les plaquettes;

– la mobilité des fixations est constamment freinée avec assez de force par les moyens supplémentaires pour que les fixations (H), en n'importe quel endroit de leur course, soient suffisamment fixées par la seule force de freinage et

– les moyens pour pousser, fermer ou ouvrir les fixations (H) comprennent des coulisseaux (15, 55).

2. Convoyeur selon la revendication 1, caractérisé par le fait que les fixations (H) peuvent pivoter vers l'intérieur à l'encontre de la force d'un ressort de rappel (F) de manière qu'après la prise en charge d'une plaquette (P) ils s'exercent sur celle-ci un effort de traction réduisant les fléchissements.

3. Convoyeur selon la revendication 1 ou 2, caractérisé par le fait que les coulisseaux (15, 55) sont respectivement raccordés à un Convoyeur d'entraînement (18, 19, 22, 24) monté à demeure dans les postes de chargement et de déchargement A, B au-dessus de la trajectoire des fixations (H).

4. Convoyeur selon les revendications 2 et 3, caractérisé par le fait que dans le poste de chargement (A) les coulisseaux (15) agissent au-dessus de l'axe de pivotement (E) des fixations (H) et que la force du ressort de rappel (F), d'une part, est plus petite que la force de freinage avec laquelle les fixations sont montées sur les traverses (9) et, d'autre part, plus grande que la force résultant du poids des plaquettes.

5. Convoyeur selon l'une des revendications précédentes, caractérisé par le fait que les fixations (H) sont formées par une pince à ressort munie de branches (1a, 1b) qui sont disposées en forme de V ouvert vers l'intérieur et qui, au niveau de leur point d'intersection, laissent subsister une fente de serrage (S) pour l'insertion des plaquettes (P).

6. Dispositif selon la revendication 5, caractérisé par le fait que la pince à ressort avec les branches (1a, 1b) est formée d'une seule pièce par une lame de ressort (1) façonnée en conséquence.

7. Convoyeur selon la revendication 5 ou 6, caractérisé par le fait que dans le poste de déchargement (B), les coulisseaux (55) agissent sur la branche supérieure (1a) de manière qu'au début de l'écartement, la pince à ressort soit ouverte dans la mesure de la différence entre la force de poussée des coulisseaux et la force de freinage avec laquelle la fixation est montée sur la traverse.

8. Convoyeur selon l'une des revendications 2 à 7, caractérisé par le fait que les moyens pour le freinage supplémentaire des fixations (H) sur les traverses (9) sont réalisés sous la forme d'un élément de freinage (6, 30b) qui est appuyé par un ressort F contre la traverse (9) et qui est disposé de façon que le ressort forme en même temps le ressort de rappel (F) pour le pivotement.

9. Convoyeur selon la revendication 8, caractérisé par le fait que la distance entre l'axe de pivotement de la fixation (H) et le plan d'encastrement des plaquettes, d'une part, et celle entre l'axe de pivotement (E) et l'extrémité supérieure de l'unité de rappel (33), d'autre part, forment un tel rapport de levier et que le ressort de rappel (F) est installé à un endroit tel que la course de pivotement (amplitude) au niveau du point d'encastrement des plaquettes, (fente de serrage S) correspond à un multiple de la course du ressort de rappel.

10. Convoyeur selon l'une des revendications 2 à 9, caractérisé par le fait que les fixations (H) reposent sur des chariots (2) qui sont montés sur les traverses (9) de manière à pouvoir pivoter de façon limitée a moyen de galets (3a, 3b, 3c) et d'un élément de freinage soumis à l'action d'un ressort, l'élément de freinage étant disposé de telle sorte que le ressort de freinage (F) forme en même temps le ressort de rappel (F) pour le pivotement.

11. Convoyeur selon l'une des revendications 2 à 9, caractérisé par le fait que les fixations reposent sur des chariots (2) qui sont montés sur les traverses (9) au moyen de sabots de glissement et de freinage (30a, 30b) assurés contre toute possibilité de déplacement longitudinal et de dérobade latérale, au moins l'un de ces patins (30b) étant appuyé élastiquement et de façon pivotable (ressort F) contre la traverse pour former le mécanisme de pivotement et de freinage.

12. Convoyeur selon l'une des revendications précédentes, caractérisé par le fait que les fixations (H) dans la zone de serrage comportent des ergots (1f) de façon à obtenir à cet endroit un contact seulement ponctuel des plaquettes (P).

13. Convoyeur selon l'une des revendications précédentes, caractérisé par le fait que chaque coulisseau (15) du poste de chargement (A) est muni d'une barrière photo-électrique (41-L-42) qui surveille la profondeur d'insertion des plaquettes (P) et, lors de la détection d'une arête d'une plaquette stoppe et inverse le système d'entraînement pneumatique du coulisseau (15).

Fig. 1

EP 0 224 440 B1

**Fig. 2**

Fig. 3

*Fig. 4*

Fig. 5

**Fig. 7**

**Fig. 6**

EP 0 224 440 B1

Fig. 9

Fig. 8

EP 0 224 440 B1

Fig. 11

Fig. 10

EP 0 224 440 B1